# EUROPÄISCHE PATENTSCHRIFT

(11) **EP 2 824 487 B1**
(45) Veröffentlichungstag und Bekanntmachung des Hinweises auf die Patenterteilung: **19.01.2022**
(21) Anmeldenummer: 14173867.4
(22) Anmeldetag: 25.06.2014
(51) Int. Cl.: G02B 5/08, G03F 7/20

(54) **Reflektives optisches Element für streifenden Einfall im EUV-Wellenlängenbereich**
Reflective optical element for oblique incidence in the EUV wavelength range
Elément optique réfléchissant pour incidence rasante dans la plage de longueurs d'onde EUV

(30) Priorität: 08.07.2013 DE 102013107192
(43) Veröffentlichungstag der Anmeldung: 14.01.2015
(73) Patentinhaber: Carl Zeiss SMT GmbH, 73447 Oberkochen (DE)
(72) Erfinder: Shklover, Vitaliy, 89551 Königsbronn (DE)
(74) Vertreter: Werner & ten Brink

(56) Entgegenhaltungen:
- WO-A1-2010/018046
- WO-A1-2011/075796
- WO-A1-2012/171674
- WO-A2-2007/090364
- DE-A1-102010 039 927
- DE-A1-102011 002 953
- DE-A1-102011 005 144
- US-A1- 2005 279 951

## Beschreibung

Die vorliegende Erfindung bezieht sich auf ein reflektives optisches Element für streifenden Einfall im extrem ultravioletten Wellenlängenbereich, das eine reflektierende Beschichtung auf einem Substrat aufweist. Ferner bezieht sich die Erfindung auf ein optisches System für die EUV-Lithographie sowie eine EUV-Lithographievorrichtung mit einem derartigen reflektiven optischen Element.

In EUV-Lithographievorrichtungen werden zur Lithographie von Halbleiterbauelementen reflektive optische Elemente für den extremen ultravioletten (EUV) Wellenlängenbereich (z.B. Wellenlängen zwischen ca. 5 nm und 20 nm) wie etwa Photomasken oder Spiegel auf der Basis von Viellagensystemen eingesetzt. Da EUV-Lithographievorrichtungen in der Regel mehrere reflektive optische Elemente aufweisen, müssen diese eine möglichst hohe Reflexionsgrad aufweisen, um einen hinreichend hohen Gesamtreflexionsgrad sicherzustellen.

Als Strahlungsquellen können u.a. Plasmaquellen dienen. Das Plasma kann durch eine Entladung (DPP-Quelle) oder bevorzugt durch Laseranregung (LPP-Quelle) erzeugt werden. Dazu werden Materialtröpfchen einer intensiven Laserstrahlung ausgesetzt, um sie zu einem Plasma anzuregen, das u.a. Strahlung im EUV-Wellenlängenbereich emittiert. Um die EUV-Strahlung zu einem möglichst hohen Anteil für die EUV-Lithographie zur Verfügung zu stellen, werden u.a. Spiegel für streifenden Einfall eingesetzt. Dabei handelt es sich in der Regel um Substrate mit einer reflektierenden Beschichtung aus Metall. Derartige Spiegel sind beispielsweise in der EP 1 882 984 A1 beschrieben. Es werden dort zum Beispiel reflektierende Beschichtungen aus Molybdän, Ruthenium, Rhodium, Palladium, Niob oder Zirkon beschrieben, die für Einfallswinkel von bis zu 15°, teilweise bis zu 20° zur Spiegeloberfläche Reflexionsgrade von über 60% erreichen.

Die DE 10 2010 039 927 A1 offenbart Spiegelsubstrate mit Polierschichten aus beispielsweise Nickel-Bor einer Dicke im Bereich von 5 µm bis 10 µm. Um daraus Spiegel zu erhalten, muss auf die Substrate zusätzlich eine reflektierende Beschichtung aufgebracht werden, beispielsweise in Form von Viellagensystemen.

Aus der WO 2011/075796 A1 ist ein Autospiegel aus Kunststoff bekannt, der eine mehrschichtige Beschichtung aufweist. Die reflektierende Schicht kann eine Borid aufweisen.

Es ist eine Aufgabe der vorliegenden Erfindung, reflektive optische Elemente für den streifenden Einfall im extrem ultravioletten Wellenlängenbereich mit einem möglichst hohen Reflexionsgrad zur Verfügung zu stellen.

Diese Aufgabe wird gelöst durch ein optisches System für die EUV-Lithographie mit einem reflektiven optischen Element für streifenden Einfall im extrem ultravioletten Wellenlängenbereich, aufweisend eine reflektierende Beschichtung auf einem Substrat, wobei die reflektierende Beschichtung ein-, zwei, drei- oder vierlagig ausgestaltet ist, die reflektierende Beschichtung eine Dicke von mehr als 50 nm aufweist und wobei die reflektierende Beschichtung als Einzelschicht aus einem Borid beliebiger Stöchiometrie eines oder mehrerer der Metalle der Gruppe Molybdän, Ruthenium, Niob, Zirkon, Rhodium, Rhenium, Palladium, Gold, Platin, Tantal, Wolfram, Osmium, Iridium, Titan, Hafnium, Magnesium, Kalzium und Strontium ausgelegt ist oder als System mit verschiedenen Schichten aus Boriden von unterschiedlichen Metallen oder Metallkombinationen der besagten Gruppe von Metallen.

Es hat sich herausgestellt, dass borhaltige reflektierende Beschichtungen wie oben genannt einer Dicke von 50 nm oder mehr einen höheren Reflexionsgrad bei streifendem Einfall von EUV-Strahlung aufweisen. Insbesondere wenn man bekannte derartige reflektive optische Elemente mit reflektiver Beschichtung einer bestimmten Zusammensetzung mit entsprechenden reflektiven optischen Elementen mit einer reflektiven Beschichtung dieser Zusammensetzung mit zusätzlich einem Borgehalt vergleicht, lassen sich gleiche Reflexionsgrade bei höheren Einfallswinkeln erreichen, was zu einem höheren Gesamtreflexionsgrad des jeweiligen reflektiven optischen Elements führt.

Die reflektierende Beschichtung weist Bor zumindest teilweise in Form eines Borids beliebiger Stöchiometrie eines oder mehrerer der Metalle der Gruppe Molybdän, Ruthenium, Niob, Zirkon, Rhodium, Rhenium, Palladium, Gold, Platin, Tantal, Wolfram, Osmium, Iridium, Titan, Hafnium, Magnesium, Kalzium und Strontium auf. Durch den Einsatz eines dieser Boride kann gegenüber der nichtboridischen Metallbeschichtung eines entsprechenden reflektiven optischen Elements ein gleicher Reflexionsgrad bei einem um einige Grad höheren Einfallswinkel, insbesondere bei Einfallswinkeln größer 15° oder mehr erreicht werden.

Die reflektierende Beschichtung kann das Bor zumindest teilweise in Form eines Metallborids beliebiger Stöchiometrie aufweisen, um eine Steigerung des Gesamtreflexionsgrad zu erreichen. Ein Borid einer Substanz A könnte beispielsweise mit AₓB_{y} mit x, y Zahlen zwischen 0 und 1 und x+y=1 beschrieben werden. Vorteilhafterweise ist die reflektierende Beschichtung als Einzelschicht oder als System mit verschiedenen Schichten aus binären oder ternären Metallboriden beliebiger Stöchiometrie ausgelegt, d.h. eine Boridverbindung von zwei oder drei Metallen, etwa M1ₓ₁M2ₓ₂By oder M1ₓ₁M2ₓ₂M3ₓ₃B_{y}. Dabei sind M1, M2, M3 unterschiedliche Metalle und x1, x2, x3, y Zahlen zwischen 0 und 1 und x1+x2+y=1 bzw. x1+x2+x3+y=1. Derartige reflektive optische Elemente zeigen verglichen mit herkömmlichen Elementen mit einer nicht boridhaltigen reflektiven optischen Beschichtung gleiche Reflexionsgrade bei 2° bis 3° höheren Einfallswinkeln, wodurch der insbesondere bei metallischen reflektiven Beschichtungen bereits hohe Reflexionsgrad bei einem bestimmten Einfallswinkel um mehrere Prozent gesteigert werden kann.

In bevorzugten Ausführungsformen weist das Borid der reflektierende Beschichtung zumindest teilweise eine Stöchiometrie auf, die über die Dicke der reflektierenden Beschichtung variiert. Auf diese Weise lassen sich andere Materialeigenschaften der Beschichtung als der Reflexionsgrad an entsprechende Eigenschaften des Substrats anpassen, insbesondere indem man in Substratnähe eine andere Borkonzentration als auf der Substrat abgewandten Seite der reflektierenden Beschichtung vorsieht. Solche Eigenschaften können beispielsweise Hafteigenschaften, Ausdehnungskoeffizienten, Spannungseigenschaften und andere sein.

Vorteilhafterweise ist das Substrat aus Metall, einer Metalllegierung, Glas, Glaskeramik, Keramik, einem ein- oder polykristallinem Halbleiter oder einem Verbundwerkstoff ist. Je nachdem welche Anforderungen an das reflektive optische Element gestellt werden, kann bei der Wahl des Substratmaterials beispielsweise die Bearbeitbarkeit, die Möglichkeit, ausgedehnte Substrate zu erhalten oder auch ein möglichst geringer Ausdehnungskoeffizient im Vordergrund stehen.

Vorteilhafterweise ist zwischen dem Substrat und der reflektierenden Beschichtung eine Haftvermittlerschicht angeordnet, um die Haftung zwischen Substrat und reflektierender Beschichtung zu verbessern. Bevorzugt weist die reflektierende Beschichtung das Bor zumindest teilweise in Form eines Metallborids oder ein Metallmischborids beliebiger Stöchiometrie auf und ist zwischen dem Substrat und der reflektiven Beschichtung eine Haftvermittlerschicht angeordnet, die das Metall des Metallborids oder eines der Metalle des Metallmischborids aufweist. Das Aufbringen der Metallschicht als Haftvermittlerschicht lässt sich bei üblichen Beschichtungsverfahren ohne größeren Aufwand mit dem Aufbringen der Boridschicht als reflektierender Beschichtung kombinieren.

In bevorzugten Ausführungsformen weist die reflektierende Beschichtung eine Dicke von 100 nm oder mehr, bevorzugt 1000 nm oder mehr auf. Es hat sich gezeigt, dass der Reflexionsgrad der borhaltigen reflektiven Beschichtung mit zunehmender Dicke zunimmt, insbesondere auch bei etwas höheren Einfallswinkeln der gleiche Reflexionsgrad wie bei dünneren Beschichtungen bei geringeren Einfallswinkeln erreicht werden kann.

In besonders bevorzugten Ausführungsformen besteht die reflektierende Beschichtung aus einer borhaltigen Lage. Insbesondere für optische reflektive optische Elemente für den streifenden Einfall können einlagige reflektierende Beschichtungen bereits ausreichende Reflektivität aufweisen. Man benötigt für streifenden Einfall keine aufwendigen Viellagensysteme, die auf Bragg-Reflexion basieren, wie bei reflektiven optischen Elementen für normalen Einfall. Je geringer die Lagenanzahl ist, desto geringer kann der Aufwand bei der Herstellung der reflektierenden Beschichtung sein.

In einer besonders bevorzugten Ausführungsform ist das reflektive optische Element als Kollektorspiegel ausgebildet. Kollektorspiegel werden in der EUV-Lithographie oft als erster Spiegel in Strahlrichtung hinter der Strahlungsquelle, insbesondere PlasmaStrahlungsquellen eingesetzt, um die von der Strahlungsquelle in verschiedene Richtungen emittierte Strahlung zu sammeln und gebündelt zum nächstfolgenden Spiegel zu reflektieren.

Ferner wird die Aufgabe gelöst durch. eine EUV-Lithographievorrichtung mit einem derartigen optischen Element.

Die vorliegende Erfindung soll unter Bezugnahme auf ein bevorzugtes Ausführungsbeispiel näher erläutert werden. Dazu zeigen
- Figur 1: schematisch eine Ausführungsform einer EUV-Lithographievorrichtung aus optischen Systemen und mit einem hier vorgeschlagenen reflektiven optischen Element;
- Figur 2: schematisch eine erste Ausführungsform eines hier vorgeschlagenen reflektiven optischen Elements;
- Figur 3: schematisch eine zweite Ausführungsform eines hier vorgeschlagenen reflektiven optischen Elements;
- Figuren 4 bis 6: schematisch verschiedene Verteilungen der Borkonzentration über die Dicke der reflektierenden Beschichtung;
- Figur 7: der Reflexionsgrad in Abhängigkeit vom Einfallswinkel einer reflektierenden Beschichtung aus Niobborid im Vergleich zu einer reflektierenden Beschichtung aus Niob;
- Figur 8: der Reflexionsgrad in Abhängigkeit vom Einfallswinkel einer reflektierenden Beschichtung aus Molybdänborid einer Dicke von 100 nm und einer Dicke von 1000 nm im Vergleich zu einer reflektierenden Beschichtung aus Molybdän; und
- Figur 9: der Reflexionsgrad in Abhängigkeit vom Einfallswinkel einer reflektierenden Beschichtung aus RuB₂ einer Dicke von 100 nm und einer Dicke von 1000 nm sowie aus RuB₁₂ einer Dicke von 100 nm und einer Dicke von 1000 nm im Vergleich zu einer reflektierenden Beschichtung aus Ruthenium.

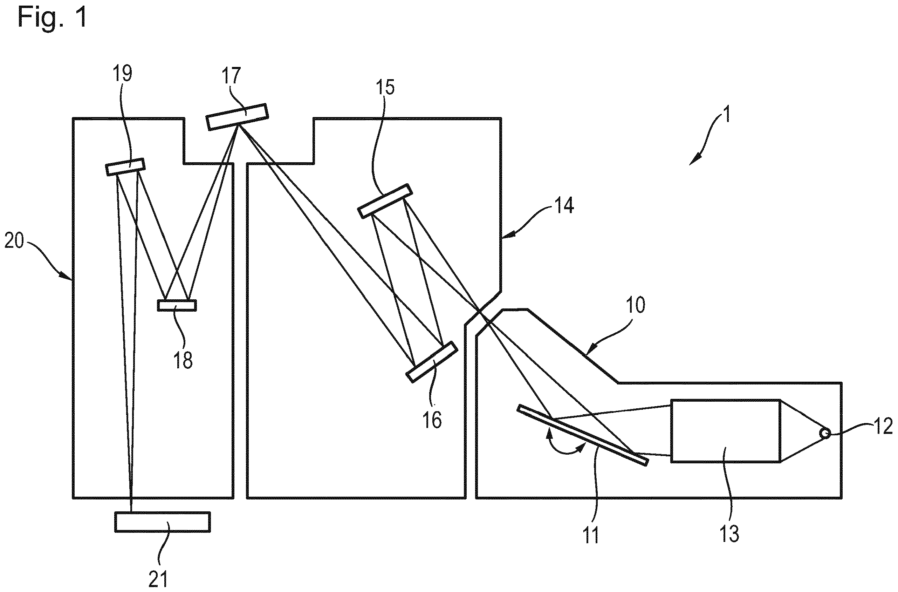

In Figur 1 ist schematisch eine EUV-Lithographievorrichtung 10 dargestellt. Wesentliche Komponenten sind das Strahlformungssystem 10, das Beleuchtungssystem 14, die Photomaske 17 und das Projektionssystem 20. Die EUV-Lithographievorrichtung 10 wird unter Vakuumbedingungen betrieben, damit die EUV-Strahlung in ihrem Inneren möglichst wenig absorbiert wird.

Als Strahlungsquelle 12 kann beispielsweise eine Plasmaquelle oder auch ein Synchrotron dienen. Im hier dargestellten Beispiel handelt es sich um eine Plasmaquelle. Die emittierte Strahlung im Wellenlängenbereich von etwa 5 nm bis 20 nm wird zunächst vom Kollektorspiegel 13 gebündelt und anschließend im hier dargestellten Beispiel mit Hilfe eines Monochromators 11 spektral gefiltert. Der Betriebsstrahl wird dann in das Beleuchtungssystem 14 eingeführt. Im in Figur 1 dargestellten Beispiel weist das Beleuchtungssystem 14 zwei Spiegel 15, 16 auf. Die Spiegel 15, 16 leiten den Strahl auf die Photomaske 17, die die Struktur aufweist, die auf den Wafer 21 abgebildet werden soll. Bei der Photomaske 17 handelt es sich ebenfalls um ein reflektives optisches Element für den EUV-Wellenlängenbereich, das je nach Herstellungsprozess ausgewechselt wird. Mit Hilfe des Projektionssystems 20 wird der von der Photomaske 17 reflektierte Strahl auf den Wafer 21 projiziert und dadurch die Struktur der Photomaske 17 auf ihn abgebildet. Das Projektionssystem 20 weist im dargestellten Beispiel zwei Spiegel 18, 19 auf. Es sei darauf hingewiesen, dass sowohl das Projektionssystem 20 als auch das Beleuchtungssystem 14 jeweils nur einen oder auch drei, vier, fünf und mehr Spiegel aufweisen können. Das Strahlformungs- und das Beleuchtungssystem können auch als ein gemeinsames optisches System ausgeführt sein. Insbesondere kann in Varianten auch auf den Monochromator 11 verzichtet werden.

Im vorliegenden Beispiel ist lediglich der Kollektorspiegel 13 als Spiegel für streifenden Einfall ausgelegt. Prinzipiell könnten auch an anderen Stellen in der EUV-Lithographievorrichtung 1 reflektive optische Elemente für streifenden Einfalls eingesetzt werden. Bei dem hier dargestellten Kollektorspiegel 13 handelt es sich um ein reflektives optisches Element für streifenden Einfall im extrem ultravioletten Wellenlängenbereich mit einer reflektierenden Beschichtung einer Dicke von mindestens 50 nm auf einem Substrat, die Bor enthält.

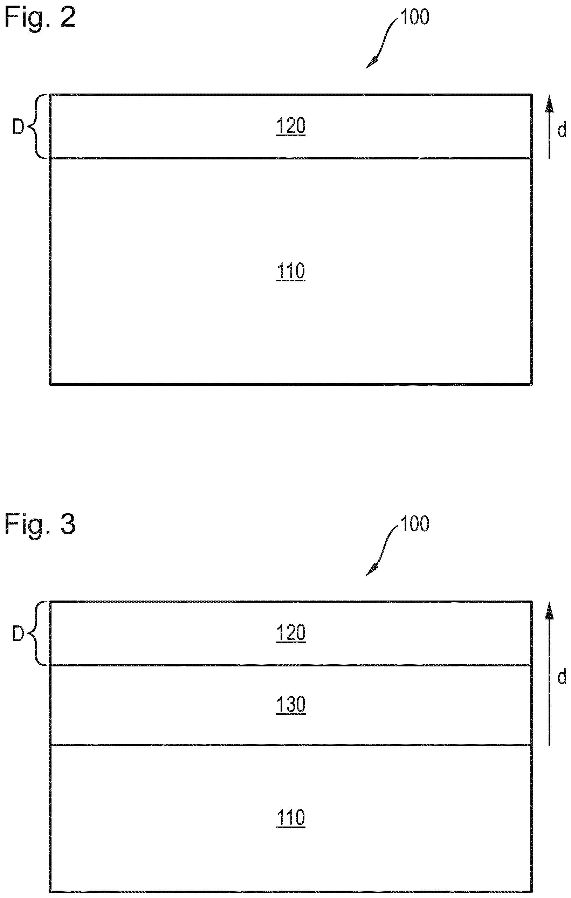

Der schematische Aufbau zweier Ausführungsformen eines reflektiven optischen Elements 100 für den streifenden Einfall mit borhaltiger reflektierenden Beschichtung 120 ist in den Figuren 2 und 3 dargestellt. Die borhaltige Beschichtung 120 ist auf einem Substrat 100 angeordnet, dass beispielsweise aus Metall, einer Metalllegierung, Glas, Glaskeramik, Keramik, einem ein- oder polykristallinem Halbleiter oder einem Verbundwerkstoff sein kann. Im in Figur 3 dargestellten Beispiels ist zur Verbesserung der Haftung der reflektierenden Beschichtung 120 auf dem Substrat 110 eine Haftvermittlerschicht 130 zwischen dem Substrat 110 und der reflektierenden Beschichtung 120 angeordnet. In diesen hier dargestellten Beispielen ist die borhaltige reflektierende Beschichtung einer Dicke von mindestens 50 nm als eine Lage 120 ausgebildet. In Varianten kann die Beschichtung auch zwei-, drei- oder vierlagig ausgebildet sein, wobei aber vorzugsweise die Lagenanzahl deutlich unter der Lagenanzahl von Viellagensystemen für den normalen Einfall liegt.

In den hier im Folgenden betrachteten exemplarischen Ausführungsbeispielen handelt es sich bei der reflektierenden Beschichtung 120 um ein Borid beliebiger Stöchiometrie, insbesondere um ein Metallborid bzw. ein Mischborid in Form eines binären oder ternären Metallborids. Dabei handelt es sich in den hier betrachteten Ausführungsbeispielen bei der reflektierenden Beschichtung um eine Einzelschicht aus einem Borid beliebiger Stöchiometrie eines oder mehrerer der Metalle der Gruppe Molybdän, Ruthenium, Niob, Zirkon, Rhodium, Rhenium, Palladium, Gold, Platin, Nickel, Tantal, Wolfram, Osmium, Iridium, Titan, Hafnium, Magnesium, Kalzium und Strontium. In weiteren Varianten kann die reflektierenden Beschichtung auch als System mit verschiedenen Schichten aus Boriden von unterschiedlichen Substanzen, insbesondere von unterschiedlichen Metallen oder Metallkombinationen ausgelegt sein.

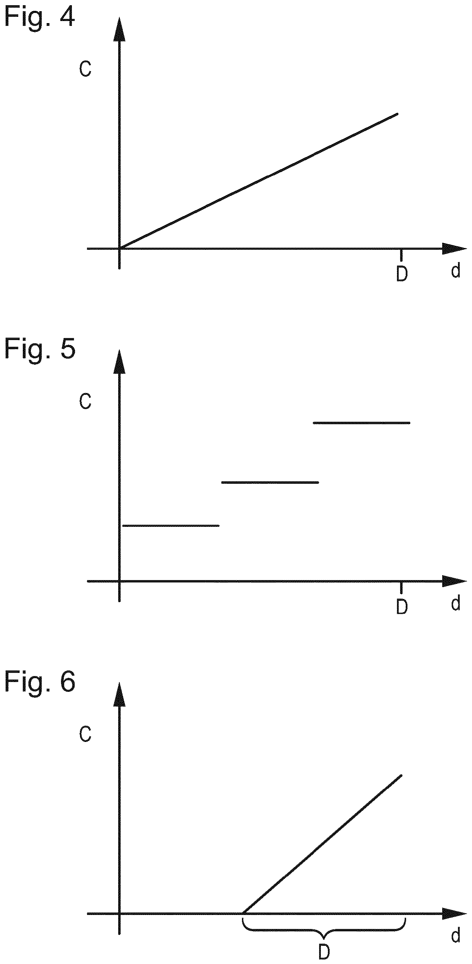

In manchen Varianten der hier exemplarisch betrachteten Ausführungsbeispielen weist die reflektierende Beschichtung 120 das Bor in Form eines Borids einer Stöchiometrie auf, die über die Dicke D der reflektierenden Beschichtung 120 variiert. Verschiedene Beispiele für die Variationen der Borkonzentration C sind schematisch in den Figuren 4 bis 6 dargestellt. Dabei wird der Verlauf der Konzentration C in Abhängigkeit vom Abstand d von der Substratoberfläche betrachtet. In den hier rein exemplarisch herausgegriffenen Beispielen steigt die Konzentration C mit zunehmenden Abstand d vom Substrat an. Dabei ist der Verlauf in den in den Figuren 4 und 6 dargestellten Beispielen stetig, während er in dem in Figur 5 dargestellten Beispiel unstetig ist und die Konzentration C in konstanten Stufen zunimmt. Im in Figur 6 dargestellten Beispiel ist die Borkonzentration C zunächst Null über die Dicke der Haftvermittlerschicht. Im hier in Figur 6 dargestellten Beispiel ist die reflektierende Beschichtung ein Metallborid oder ein Metallmischborid beliebiger Stöchiometrie und ist die Haftvermittlerschicht das Metall des Metallborids oder ggf. eines der Metalle des Metallmischborids der reflektierenden Beschichtung.

Hergestellt werde die hier vorgeschlagenen reflektiven optischen Elemente im wesentlichen auf herkömmliche Weise: In einem ersten Schritt wird eine Form, auch Mandrel genannt, aus Metall, Metalllegierung, Glas, Glaskeramik, Keramik, ein- bzw. polykristallinem Halbleiter oder Verbundwerkstoff hergestellt und mit bekannten Verfahren bis zur erforderlichen Rauheit poliert. Eine zu hohe Rauheit würde zu einer Minderung des Reflexionsgrades führen. Optional kann auf die Form eine Trennschicht aus Metall, Metalllegierung, Glas, Halbleiter oder Kunststoff, beispielsweise Parylen abgeschieden werden. Darüber wird die borhaltige reflektierende Beschichtung abgeschieden, beispielsweise mittels physikalische Gasphasenabscheidung, insbesondere Sputtern, etwa Magnetronsputtern oder reaktives Sputtern, oder chemische Gasphasenabscheidung bzw. Atomlagenabscheidung, insbesondere plasmaunterstützt, partikelstrahlunterstützt, photounterstützt oder auch als metallorganischer Gasphasenabscheidung. Optional kann darauf eine weitere Schicht als Haftvermittlerschicht abgeschieden werden. Anschließend wird zur mechanischen Verstärkung ein Substrat aufgebracht. Dies kann beispielsweise durch Galvanisieren, Gasphasen- oder Atomlagenabscheidung, Plasmaspritzen, Lasersintern, Mikrowellensintern oder auch lokalen Materialaufbau in der Art von dreidimensionalem Drucken geschehen. Dabei können beispielsweise auch Kühlkanäle eingebaut werden. Diese sind insbesondere bei der späteren Verwendung als Kollektorspiegel von Vorteil, da er wegen seiner Nähe zur Strahlungsquelle einer sehr hohen Wärmelast ausgesetzt ist. In einem letzten Schritt wird der Spiegel vom Mandrel durch Auseinanderziehen getrennt. Eine eventuelle Trennschicht kann dabei am Mandrel oder der reflektierenden Beschichtung haften bleiben. In letzterem Fall kann sie durch plasma-, photo- oder partikelunterstützte oder auch nasschemische Verfahren entfernt werden.

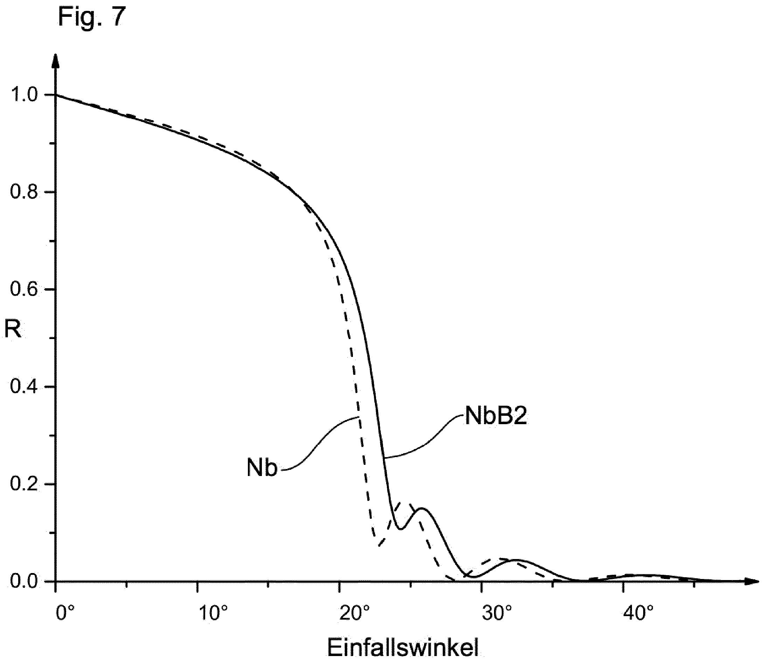

In den Figuren 7 bis 9 sind die Reflexionsgrade in Abhängigkeit vom Einfallswinkel (gemessen von der Spiegelflächenebene bzw. senkrecht zur Flächennormalen) für einige beispielhafte Materialien für die reflektierende Beschichtung von Spiegeln für streifenden Einfall bei einer Wellenlänge von 13,5 nm dargestellt. Die Beschichtungen sind in den hier diskutierten Beispielen einlagig ausgeführt, d.h. sie bestehen aus jeweils einer Schicht. Den Berechnungen liegen die Werte für die optischen Konstanten aus B.L. Henke, E.M. Gullikson, and J.C. Davis: X-ray interactions: photoabsorption, scattering, transmission, and reflection at E=50-30000 eV, Z=1-92, Atomic Data and Nuclear Data Tables Vol. 54 (no.2), 181-342 (July 1993) zugrunde.

In Figur 7 ist der Reflexionsgrad für eine reflektierende Beschichtung aus Niobborid auf einem beliebigen Substrat dargestellt, speziell der Reflexionsgrad einer reflektierenden Beschichtung aus einer etwa 100 nm dicken NbB₂-Schicht (durchgezogene Linie). Im Vergleich dazu ist auch der Reflexionsgrad eines Spiegels für streifenden Einfall mit einer etwa 100 nm dicken Niobschicht als reflektierender Beschichtung dargestellt (lang gestrichelte Linie). Während der herkömmliche Spiegel mit einer Niobschicht einen Reflexionsgrad von 60% oder mehr nur bis zu Einfallswinkeln bis ca. 20° erreicht, werden mit einer Niobboridschicht derartige Reflexionsgrade bis etwa 21,5° erreicht, wodurch sich der Gesamtreflexionsgrad über alle Winkel integriert merkbar steigern lässt.

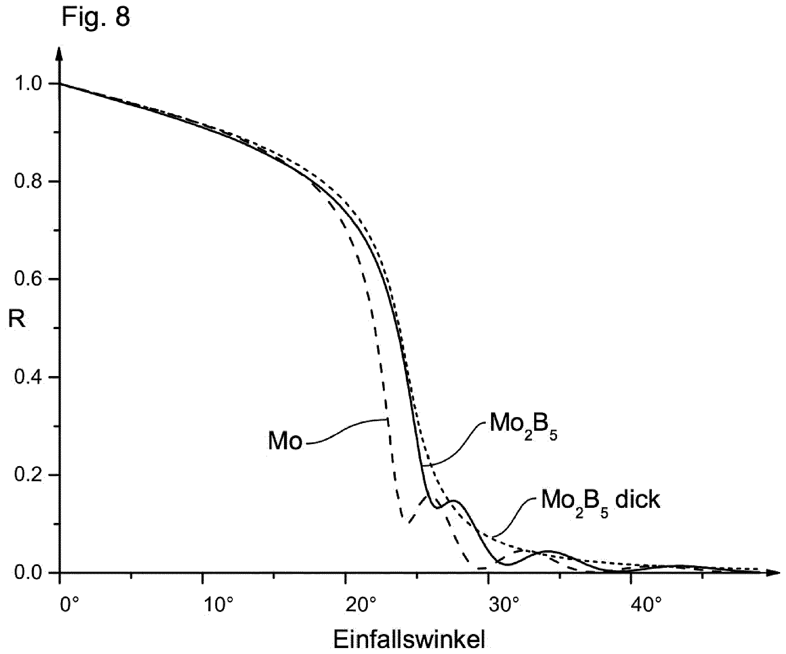

In Figur 8 ist der Reflexionsgrad für eine reflektierende Beschichtung aus Molybdänborid auf einem beliebigen Substrat dargestellt, speziell der Reflexionsgrad einer reflektierenden Beschichtung aus einer etwa 100 nm dicken Mo₂B₅-Schicht (durchgezogenen Linie) sowie einer etwa 1000 nm dicken Mo₂B₅-Schicht (kurz gestrichelte Linie). Im Vergleich dazu ist auch der Reflexionsgrad eines Spiegels für streifenden Einfall mit einer etwa 100 nm dicken Molybdänschicht als reflektierender Beschichtung dargestellt (lang gestrichelte Linie). Während der herkömmliche Spiegel mit einer Molybdänbschicht einen Reflexionsgrad von 60% oder mehr nur bis zu Einfallswinkeln bis ca. 21° erreicht, werden mit einer Molybdänboridschicht derartige Reflexionsgraden bis etwa 22,5° erreicht, wodurch sich der Gesamtreflexionsgrad über alle Einfallswinkel integriert merkbar steigern lässt. Betrachtet man die dicke Molybdänboridschicht stellt man fest, dass sie Festkörpereigenschaften zu zeigen scheint und dadurch bei höheren Einfallswinkeln keine auf Interferenzerscheinungen zurückzuführenden Reflexionsgradsschwankungen zu beobachten sind, was zusätzlich zu einer leichten Erhöhung des Gesamtreflexionsgrades führt.

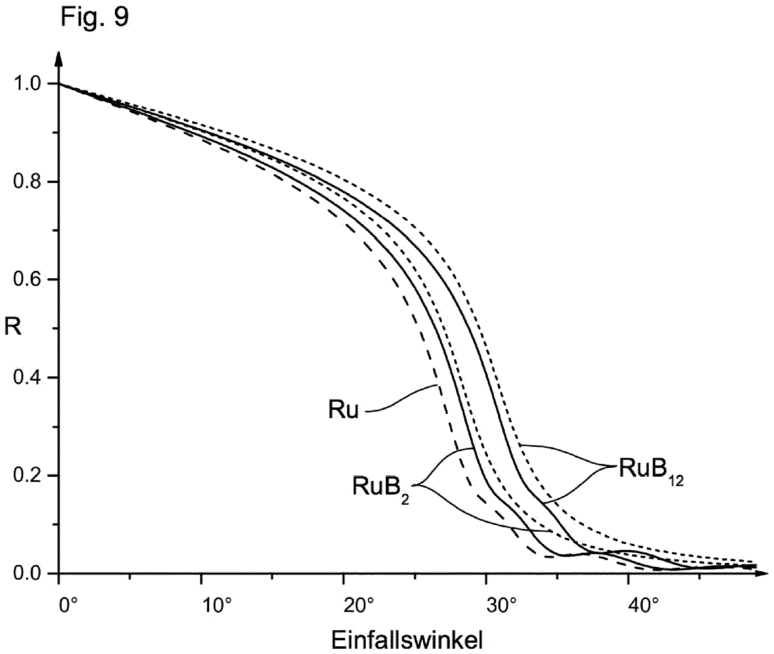

In Figur 9 ist der Reflexionsgrad für reflektierende Beschichtungen aus zwei verschiedenen Rutheniumboriden, nämliche RuB₂ und RuB₁₂ auf jeweils einem beliebigen Substrat dargestellt, speziell der Reflexionsgrad von reflektierenden Beschichtungen aus einer etwa 100 nm dicken Rutheniumboridschicht (durchgezogene Linien) sowie einer etwa 1000 nm dicken Rutheniumboridschicht (kurz gestrichelte Linien). Im Vergleich dazu ist auch der Reflexionsgrad eines Spiegels für streifenden Einfall mit einer etwa 100 nm dicken Rutheniumschicht als reflektierender Beschichtung dargestellt (lang gestrichelte Linie). Während der herkömmliche Spiegel mit einer Rutheniumschicht einen Reflexionsgrad von 60% oder mehr nur bis zu Einfallswinkeln bis ca. 23,5° erreicht, werden mit einer dünnen RuB₂-Schicht derartige Reflexionsgraden bis etwa 24,5° erreicht und durch eine dünne RuB₁₂-Schicht sogar bis etwa 26,5°, wodurch sich der Gesamtreflexionsgrad über alle Winkel integriert merkbar steigern lässt. Indem man die jeweilige Rutheniumboridschicht als etwa 1000 nm dicke Schicht aufbringt, lässt sich ein Reflexionsgrad von 60% oder mehr sogar bis zu Einfallswinkeln von bis zu etwa 25,5° für eine RuB₂-Schicht oder bis zu ca. 27,5° für eine RuB₁₂-Schicht erreichen.

Durch die Verschiebung hoher Reflexionsgrade zu höheren Einfallswinkeln um sogar bis zu 2° bis 3° durch den Einsatz von Bor in den reflektierenden Beschichtungen von Spiegeln für den streifenden Einfall im EUV-Wellenlängenbereich verglichen mit herkömmlichen Spiegeln mit reflektierenden Beschichtungen aus Metall, lässt sich bei bestimmten Einfallswinkeln eine Änderung im Reflexionsgrad vom mehreren Prozent beim jeweiligen Einfallswinkel erreichen. Berücksichtig man zudem, dass die Strahlung z.B. in Ausgestaltungen als Kollektorspiegel mehrfach reflektiert wird, kann eine Steigerung des Gesamtreflexionsgrades von etwa 5% erreicht werden. Zusätzlich ist von Vorteil, dass sich insbesondere Metallboride oder Metallmischboride durch sehr hohe Härte und thermische Beständigkeit auszeichnen, was es erlaubt, auf das Aufbringen von Schutzschichten auf der reflektierenden Beschichtung zu verzichten, die in der Regel zu einer leichten Reduzierung der Reflexionsgrad führen können. Außerdem sind diese reflektiven optischen Elemente dadurch besonders gut für den Einsatz als Kollektorspiegel in unmittelbarer Nähe von Plasmastrahlungsquellen geeignet.

### Bezugszeichen

- 10: EUV-Lithographievorrichtung
- 12: EUV-Strahlungsquelle
- 13: Kollektorspiegel
- 14: Beleuchtungssystem
- 15: erster Spiegel
- 16: zweiter Spiegel
- 17: Maske
- 18: dritter Spiegel
- 19: vierter Spiegel
- 20: Projektionssystem
- 21: Wafer
- 100: Spiegel
- 110: Substrat
- 120: reflektierende Beschichtung
- 130: Haftvermittler

- d, D: Dicke

## Patentansprüche

1. Optisches System für die EUV-Lithographie mit einem reflektiven optischen Element (100) für streifenden Einfall im extrem ultravioletten Wellenlängenbereich, aufweisend eine reflektierende Beschichtung (120) auf einem Substrat (110), **dadurch gekennzeichnet, dass**
- die reflektierende Beschichtung (120) ein-, zwei, drei- oder vierlagig ausgestaltet ist,
- die reflektierende Beschichtung (120) eine Dicke (D) von mehr als 50 nm aufweist und
- die reflektierende Beschichtung (120) als Einzelschicht aus einem Borid beliebiger Stöchiometrie eines oder mehrerer der Metalle der Gruppe Molybdän, Ruthenium, Niob, Zirkon, Rhodium, Rhenium, Palladium, Gold, Platin, Tantal, Wolfram, Osmium, Iridium, Titan, Hafnium, Magnesium, Kalzium und Strontium ausgelegt ist, oder als System mit verschiedenen Schichten aus Boriden von unterschiedlichen Metallen oder Metallkombinationen der besagten Gruppe von Metallen.

2. Optisches System nach Anspruch 1, **dadurch gekennzeichnet, dass** die reflektierende Beschichtung (120) als Einzelschicht oder als System mit verschiedenen Schichten aus binären oder ternären Metallboriden beliebiger Stöchiometrie ausgelegt.

3. Optisches System nach Anspruch 1 oder 2, **dadurch gekennzeichnet, dass** die reflektierende Beschichtung (120) ein Borid einer Stöchiometrie aufweist, die über die Dicke (D) der reflektierenden Beschichtung (120) variiert, indem die Borkonzentration über die Dicke (D) der reflektierenden Beschichtung (120) variiert.

4. Optisches System nach einem der Ansprüche 1 bis 3, **dadurch gekennzeichnet, dass** das Substrat (110) aus Metall, einer Metalllegierung, Glas, Glaskeramik, Keramik, einem ein- oder polykristallinem Halbleiter oder einem Verbundwerkstoff ist.

5. Optisches System nach einem der Ansprüche 1 bis 4, **dadurch gekennzeichnet, dass** zwischen dem Substrat (110) und der reflektierenden Beschichtung (120) eine Haftvermittlerschicht (130) angeordnet ist.

6. Optisches System nach einem der Ansprüche 1 bis 5, **dadurch gekennzeichnet, dass** die reflektierende Beschichtung (120) das Borid in Form eines Metallborids oder eines Metallmischborids beliebiger Stöchiometrie aufweist und zwischen dem Substrat (110) und der reflektiven Beschichtung (120) eine Haftvermittlerschicht (130) angeordnet ist, die das Metall des Metallborids oder eines der Metalle des Metallmischborids aufweist.

7. Optisches System nach einem der Ansprüche 1 bis 6, **dadurch gekennzeichnet, dass** die reflektierende Beschichtung (120) eine Dicke (D) von mehr als 100 nm, bevorzugt 1000 nm oder mehr aufweist.

8. Optisches System nach einem der Ansprüche 1 bis 7, **dadurch gekennzeichnet, dass** die reflektierende Beschichtung aus einer Borid-Lage (120) besteht.

9. Optisches System nach einem der Ansprüche 1 bis 8, **dadurch gekennzeichnet, dass** das reflektive optische Element als Kollektorspiegel (13) ausgebildet ist.

10. EUV-Lithographievorrichtung mit einem optischen System gemäß einem der Ansprüche 1 bis 9.

## Claims

1. Optical system for EUV lithography, comprising a reflective optical element (100) for grazing incidence in the extreme ultraviolet wavelength range, having a reflective coating (120) on a substrate (110), **characterized in that**
- the reflective coating (120) is configured to have one, two, three or four layers,
- the reflective coating (120) has a thickness (D) of more than 50 nm and
- the reflective coating (120) is designed as a single layer made of a boride of any stoichiometry of one or more metals of the group of molybdenum, ruthenium, niobium, zircon, rhodium, rhenium, palladium, gold, platinum, tantalum, tungsten, osmium, iridium, titanium, hafnium, magnesium, calcium and strontium, or as a system with different layers made of borides of different metals or metal combinations of said group of metals.

2. Optical system according to Claim 1, **characterized in that** the reflective coating (120) is designed as a single layer or as a system with different layers made of binary or ternary metal borides of any stoichiometry.

3. Optical system according to Claim 1 or 2, **characterized in that** the reflective coating (120) contains a boride of a stoichiometry which varies over the thickness (D) of the reflective coating (120) by virtue of the boron concentration varying over the thickness (D) of the reflective coating (120).

4. Optical system according to any one of Claims 1 to 3, **characterized in that** the substrate (110) is made of metal, a metal alloy, glass, glass ceramic, ceramic, a monocrystalline or polycrystalline semiconductor, or a composite material.

5. Optical system according to any one of Claims 1 to 4, **characterized in that** an adhesion promoter layer (130) is arranged between the substrate (110) and the reflective coating (120).

6. Optical system according to any one of Claims 1 to 5, **characterized in that** the reflective coating (120) contains the boride in the form of a metal boride or a mixed metal boride of any stoichiometry, and an adhesion promoter layer (130) which contains the metal of the metal boride or one of the metals of the mixed metal boride is arranged between the substrate (110) and the reflective coating (120).

7. Optical system according to any one of Claims 1 to 6, **characterized in that** the reflective coating (120) has a thickness (D) of more than 100 nm, preferably 1000 nm or more.

8. Optical system according to any one of Claims 1 to 7, **characterized in that** the reflective coating consists of a boride layer (120).

9. Optical system according to any one of Claims 1 to 8, **characterized in that** the reflective optical element is in the form of a collector mirror (13).

10. EUV lithography apparatus having an optical system according to any one of Claims 1 to 9.

## Revendications

1. Système optique destiné à la lithographie EUV, ledit système comprenant un élément optique (100) réfléchissant à une incidence rasante dans la gamme de longueurs d'onde ultraviolettes extrêmes et pourvu d'un revêtement réfléchissant (120) sur un substrat (110), **caractérisé en ce que**
- le revêtement réfléchissant (120) comporte une, deux, trois ou quatre couches,
- le revêtement réfléchissant (120) a une épaisseur (D) de plus de 50 nm et
- le revêtement réfléchissant (120) est formé d'une seule couche comprenant un borure de stœchiométrie quelconque d'un ou plusieurs des métaux du groupe comprenant le molybdène, le ruthénium, le niobium, le zirconium, le rhodium, le rhénium, le palladium, l'or, le platine, le tantale, le tungstène, l'osmium, l'iridium, le titane, le hafnium, le magnésium, le calcium et le strontium, ou d'un système comprenant différentes couches de borures de différents métaux ou de combinaisons de métaux dudit groupe de métaux.

2. Système optique selon la revendication 1, **caractérisé en ce que** le revêtement réfléchissant (120) est formé d'une seule couche ou d'un système de différentes couches comprenant des borures métalliques binaires ou ternaires de stœchiométrie quelconque.

3. Système optique selon la revendication 1 ou 2, **caractérisé en ce que** le revêtement réfléchissant (120) comporte un borure d'une stœchiométrie qui varie sur l'épaisseur (D) du revêtement réfléchissant (120) du fait que la concentration en bore varie sur l'épaisseur (D) du revêtement réfléchissant (120).

4. Système optique selon l'une des revendications 1 à 3, **caractérisé en ce que** le substrat (110) est en métal, en alliage métallique, en verre, en vitrocéramique, en céramique, en semi-conducteur monocristallin ou polycristallin ou en matériau composite.

5. Système optique selon l'une des revendications 1 à 4, **caractérisé en ce qu'**une couche de promoteur d'adhérence (130) est disposée entre le substrat (110) et le revêtement réfléchissant (120).

6. Système optique selon l'une des revendications 1 à 5, **caractérisé en ce que** le revêtement réfléchissant (120) comporte le borure sous la forme d'un borure métallique ou d'un borure d'alliage métallique de stœchiométrie quelconque et une couche de promoteur d'adhérence (130), qui comprend le métal du borure métallique ou l'un des métaux du borure d'alliage métallique, est disposée entre le substrat (110) et le revêtement réfléchissant (120).

7. Système optique selon l'une des revendications 1 à 6, **caractérisé en ce que** le revêtement réfléchissant (120) a une épaisseur (D) de plus de 100 nm, de préférence de 1000 nm ou plus.

8. Système optique selon l'une des revendications 1 à 7, **caractérisé en ce que** le revêtement réfléchissant comprend une couche de borure (120).

9. Système optique selon l'une des revendications 1 à 8, **caractérisé en ce que** l'élément optique réfléchissant est conçu sous la forme d'un miroir collecteur (13).

10. Dispositif de lithographie EUV comprenant un système optique selon l'une des revendications 1 à 9.
